# EUROPEAN PATENT SPECIFICATION

(11) **EP 4 697 732 B1**
(45) Date of publication and mention of the grant of the patent: **09.12.2026**
(21) Application number: 25170180.1
(22) Date of filing: 11.04.2025
(51) Int. Cl.: H04N 21/436, H01R 13/42, H01R 13/422, H01R 13/436, H01R 27/00, H04N 5/268, H04N 7/04, H04N 7/10, H04N 7/15, H04N 21/4363, H04N 21/4367, H04N 1/64, H04N 5/38, H04N 7/08, H04N 21/61

(54) **IMAGE TRANSMISSION EQUIPMENT AND ITS HOST DEVICE**
BILDÜBERTRAGUNGSGERÄT UND HOST-VORRICHTUNG DAFÜR
EQUIPEMENT DE TRANSMISSION D'IMAGES ET SON DISPOSITIF HÔTE

(30) Priority: 16.08.2024 TW 113208887 U
(43) Date of publication of application: 18.02.2026
(73) Proprietor: Nimbletech Digital Inc., New Taipei City 23511 (TW)
(72) Inventor: CHEN, Chih-Yang, 23511 New Taipei City (TW)
(74) Representative: HGF

(56) References cited:
- CN-U- 201 528 088
- CN-U- 207 398 532
- CN-U- 218 732 127
- NIMBLETECH /: "QuattroPod Lite LT01 Specification", 31 January 2020 (2020-01-31), XP093292715, Retrieved from the Internet <URL:https://av.company/avcpdf/EZCast/QuattroPod%20Lite%20spec-V1.01-AMC.pdf> [retrieved on 20250704]

## Description

### BACKGROUND

### Field of Invention

The present disclosure relates to an image transmission equipment, in particular to an image transmission equipment and its host device, which are capable of quickly replacing cables.

### Description of Related Art

Conventionally, when a user desires to move the content of a mobile device (e.g., a laptop, a tablet or a smartphone) to a larger display equipment (such as a TV or projector) for viewing, the user usually physically plugs a transmission line of an image transmission equipment to a connection interface of the mobile device so as to wirelessly project the image onto the larger display equipment.

However, since the specification of the connection interface of the mobile device on the market (e.g., HDMI or Type-C) vary, and the main device and its transmission line of the image transmission equipment are integrally connected to each other and cannot (or at least not easily) be unplugged, therefore, the industry must provide a variety of image transmission equipments with different specifications of transmission lines for different specifications of interface types, thereby adding a lot of additional manufacturing and storage costs, and causing trouble for the public in use.
XP093292715, Nimbletech /: "QuattroPod Lite LT01 Specification", Jan 2020, Retrieved from the Internet: URL:https://av.company/avcpdf/EZCast/ Quattro Pod%20Lite%20spec-V1.01-AMC.pdf is a specification of a powerful but low cost WiFi Presentation System product.
CN201528088 relates to a high-definition digital HDMI connecting wire joint, which comprises a plug end and a socket end.

### SUMMARY

The present disclosure proposes an image transmission equipment and its host device for overcoming or alleviating the problems of the prior art.

In one or more embodiments, an image transmission equipment includes a host device and a transmission line. The host device includes a casing, a working module and a fastening mechanism. The fastening mechanism is disposed within the casing, and movably located within the casing. The working module is disposed within the casing, and includes a wiring board, a first electrical connection slot and a second electrical connection slot. The wiring board is fixed within the casing, the second electrical connection slot and the first electrical connection slot are respectively fixedly located at two opposite surfaces of the wiring board, and collectively located on the same side of the wiring board, and the fastening mechanism is movably located within the casing. The transmission line includes a cable body, a first wire body, a second wire body, a fastening groove, a first electrical connector, a second electrical connector, a third electrical connector and a fourth electrical connector. The first electrical connector and the second electrical connector are respectively located at two opposite ends of the cable body, and the first electrical connector is pluggably connected to the first electrical connection slot, and the second electrical connector is used to connect a signal source device, and the fastening groove is located on the cable body. The first wire body comprises a first end portion and a second end portion which are opposite to each other, the first end portion loading the first electrical connector, the second end portion loading the second electrical connector. The fastening groove is recessed on a surface of the first end portion. One end of the second wire body is provided with a third end portion, and the other end of the second wire body is integrally connected to the first end portion of the first wire body. The third electrical connector and the first electrical connector are stacked together inside the first end portion of the first wire body and the third electrical connector is pluggably connected to the second electrical connection slot. The third end portion of the second wire body loads the fourth electrical connector, and the fourth electrical connector is electrically connected to the third electrical connector by the second wire body connected ot the signal source device. When the first electrical connector is connected to the first electrical connection slot, the transmission line synchronously connects the third electrical connector to the second electrical connection slot, and the fastening mechanism is moved into the fastening groove, the transmission line is fixed on the host device.

In one or more embodiments of the aforementioned image transmission equipment, the casing is provided with a sliding groove, a fixing frame and a through hole, which are located on a bottom surface of the casing, respectively. The fastening mechanism is provided with a hook body, an operated portion and an elastic member. The hook body is movably located on the fixing frame and slidably located in the sliding groove for moving into the fastening groove, the elastic member is connected to the hook body and the fixing frame, respectively, and the operated portion is located on an outer surface of the casing, and connected to the hook body through the through hole.

In one or more embodiments of the aforementioned image transmission equipment, the first electrical connection slot and the first electrical connector are complementary in structure, and the first electrical connection slot and the first electrical connector both comply with one of signal formats including HDMI, mini HDMI, micro HDMI, DP, mini DP, USB, mini USB, micro USB, USB Lightning and USB Type-C.

In one or more embodiments of the aforementioned image transmission equipment, the second electrical connector complies with one of signal formats including HDMI input/output, USB Type-C, ALT-mode input/output, HID input/output, UVC input/output, UAC input/output, and MSC access.

In one or more embodiments of the aforementioned image transmission equipment, the working module further comprises a signal transceiver portion electrically connected to the wiring board and the first electrical connection slot, and used to connect to one of a receiving-end device and a transmitting-end device.

In one or more embodiments of the aforementioned image transmission equipment, the signal transceiver portion and the first electrical connection slot are respectively located on the same side or different sides of the wiring board.

In sum, through the above structure, the image transmission equipment and its host device disclosed herein are capable of quickly replacing cables to perform different signal conversions, which not only effectively simplifies the installation and disassembly operations, but also greatly improves the convenience of use thereby not increasing additional costs and reducing the trouble caused by use.

It is to be understood that both the foregoing general description and the following detailed description are by examples, and are intended to provide further explanation of the disclosure as claimed.

### BRIEF DESCRIPTION OF THE DRAWINGS

The disclosure can be more fully understood by reading the following detailed description of the embodiment, with reference made to the accompanying drawings as follows:
Fig. 1 illustrates a perspective view of an image transmission equipment according to one embodiment of the present disclosure.
Fig. 2 illustrates an exploded view of the image transmission equipment shown in Fig. 1.
Fig. 3 illustrates an exploded view of the host device shown in Fig. 2.
Fig. 4 illustrates a schematic view of a transmission line shown in Fig. 2 viewed from another aspect.
Fig. 5 illustrates an exploded view of the host device shown in Fig. 3 viewed from another aspect.
Fig. 6 illustrates a schematic view of the image transmission equipment shown in Fig. 1 viewed from another aspect to see through a bottom shell of the host device.
Fig. 7 illustrates a partial enlarged view of an area M in Fig. 6.
Fig. 8 illustrates an exploded view of an image transmission equipment according to one embodiment of the present disclosure.

### DETAILED DESCRIPTION

Reference will now be made in detail to the present embodiments, examples of which are illustrated in the accompanying drawings. Wherever possible, the same reference numbers are used in the drawings and the description to refer to the same or like parts.

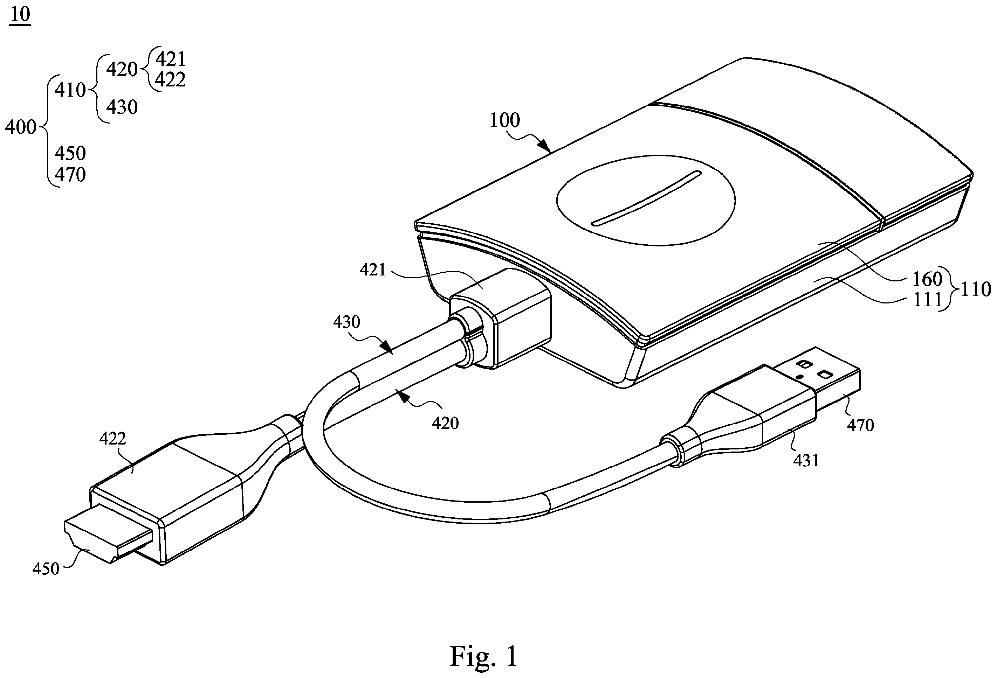

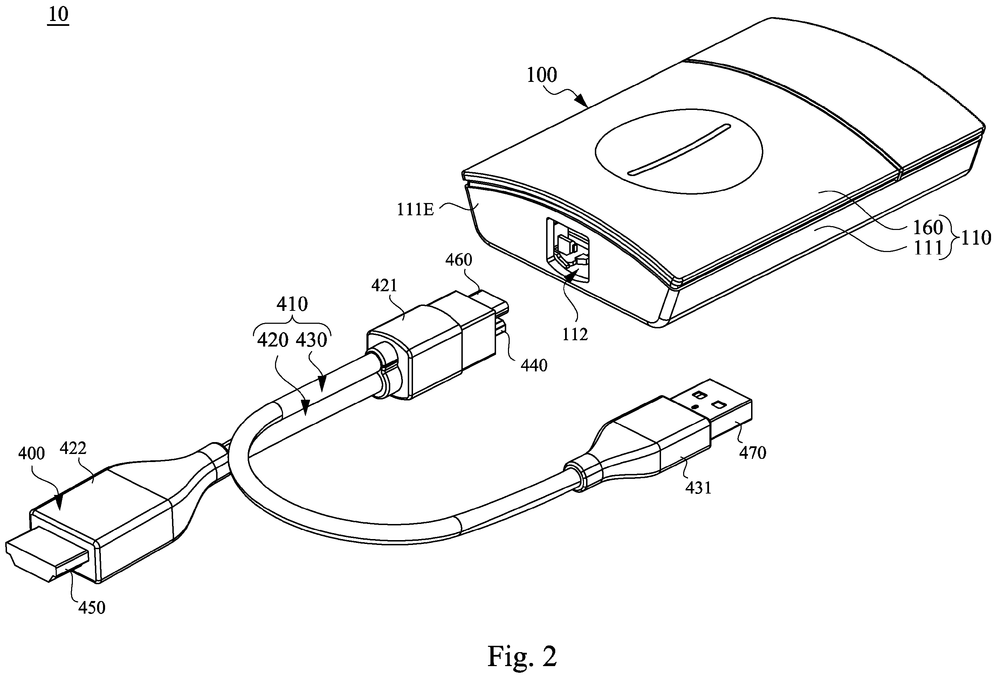

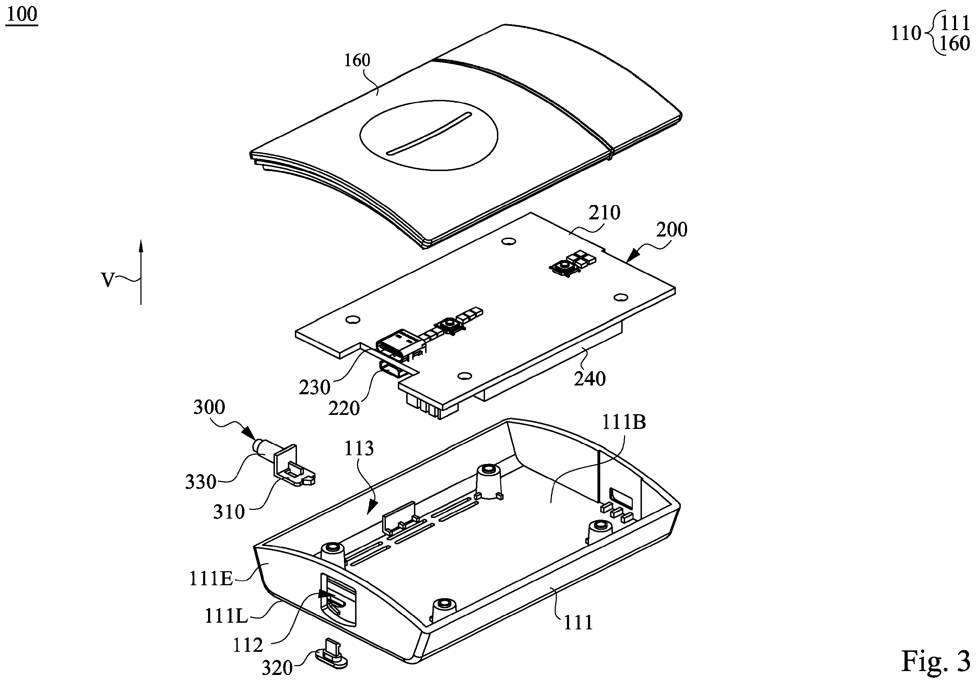

Referring to Fig. 1 to Fig.3, Fig. 1 illustrates a perspective view of an image transmission equipment 10 according to one embodiment of the present disclosure.Fig. 2 illustrates an exploded view of the image transmission equipment 10 shown in Fig. 1.Fig. 3 illustrates an exploded view of the host device 100 shown in Fig. 2. As shown in Fig.1 to Fig. 3, in the embodiement, the image transmission equipment 10 includes a host device 100 and a transmission line 400. The host device 100 includes a casing 110, a working module 200 and a fastening mechanism 300 (Fig. 3). The casing 110 includes a plugging-hole 112 and an inner space (not shown in figures). The plugging-hole 112 is formed on the casing 110 to be in communication with the inner space of the casing 110. The working module 200 includes a wiring board 210, a first electrical connection slot 220, and a second electrical connection slot 230. The wiring board 210 is fixed within the inner space of the casing 110. The first electrical connection slot 220 and the second electrical connection slot 230 are fixed on two opposite surfaces of the wiring board 210 in a vertical direction V, and the first electrical connection slot 220 and the second electrical connection slot 230 are located on the same side of the wiring board 210. The fastening mechanism 300 is movably disposed within the inner space of the casing 110. However, the present disclosure is not limited thereto, and in other embodiments, the first electrical connection slot and the second electrical connection slot may also be fixed on the same surface of the wiring board.

More specifically, in this embodiment, as shown in Fig. 2 and Fig. 3, the casing 110 further includes a bottom shell 111 and a cover 160. The bottom shell 111 is recessed with a receiving groove 113 at one surface thereof, and the receiving groove 113 for accommodating all components of the host device 100 (e.g., the working module 200 and the fastening mechanism 300). The plugging-hole 112 is formed on the bottom shell 111 at one end surface 111E thereof. After the cover 160 covers the bottom shell 111 and the receiving groove 113, the aforementioned inner space can be defined together through the cover 160 and the bottom shell 111.

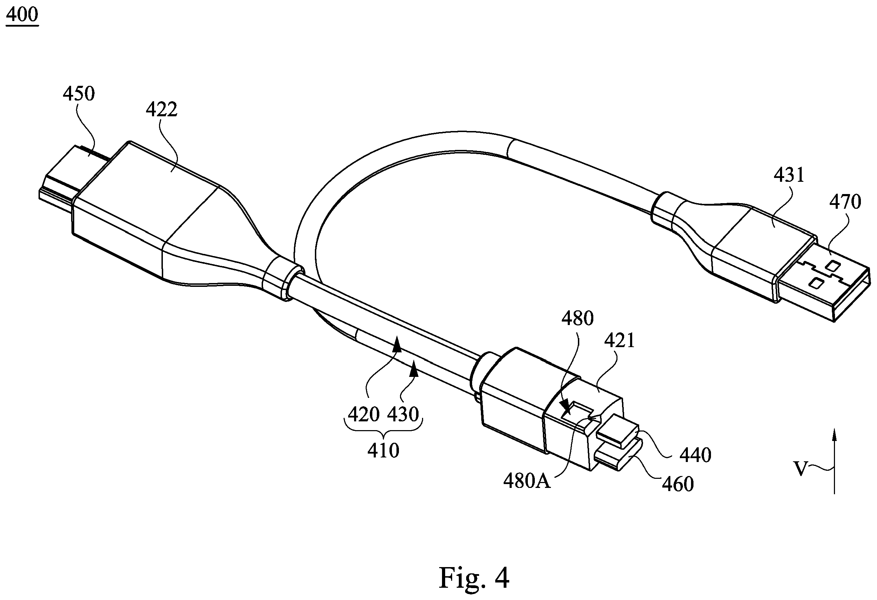

Fig. 4 illustrates a schematic view of a transmission line 400 shown in Fig. 2 viewed from another aspect. As shown in Fig. 2 and Fig. 3, in the embodiement, the transmission line 400 includes a cable body 410, a first electrical connector 440, a second electrical connector 450, a third electrical connector 460 and a fourth electrical connector 470. The first electrical connector 440 and the second electrical connector 450 are respectively fixed at two opposite ends of the cable body 410, and electrically connected to each other through the cable body 410. The first electrical connector 440 can be plugged into the casing 110 through the plugging-hole 112, and pluggably connected to the first electrical connection slot 220. The second electrical connector 450 is used to be pluggably connected to a connection interface of a signal source device (not shown in firgures) so that the electrical signal of the signal source device can be transmitted from the first electrical connector 440 to the working module 200 through the transmission line 400. The signal source device is, for example, a notebook computer, a tablet computer, a smart phone or other similar mobile devices, however, the disclosure is not limited thereto.

More specifically, the cable body 410 includes a first wire body 420 and a second wire body 430. The first wire body 420 includes a first end portion 421 and a second end portion 422 opposite to each other. The first end portion 421 loads the first electrical connector 440, the second end portion 422 loads the second electrical connector 450, and a fastening groove 480 is further recessed on a surface of the first end portion 421 (Fig. 4). The fastening groove 480 is formed with a first guiding inclined surface 480A. The first guiding inclined surface 480A is connected to the fastening groove 480 and the surface of the first end portion 421.

In this embodiment, the first electrical connector 440 is protrudingly disposed on the first end portion 421, and the second electrical connector 450 is protrudingly disposed on the second end portion 422. The first electrical connector 440 and the third electrical connector 460 are sequentially stacked within the first end portion 421 of the first wire body 420 along the vertical direction V. Furthermore, the first electrical connector 440 and the third electrical connector 460 are both received within the first end portion 421, and both protrude outward from the first end portion 421. The third electrical connector 460 is plugged into the casing 110 through the plugging-hole 112 and pluggably connected to the second electrical connection slot 230.

Thus, as shown in Fig. 3 and Fig. 4, when the first electrical connector 440 is plugged into the first electrical connection slot 220, the transmission line 400 simultaneously renders the third electrical connector 460 to be plugged into the second electrical connection slot 230. One end of the second wire body 430 is a third end portion 431. The third end portion 431 loads the fourth electrical connector 470 and the fourth electrical connector 470 is electrically connected to the third electrical connector 460 through the second wire body 430 so that the power signal of the signal source device is transmitted from the third electrical connector 460 to the working module 200 through the transmission line 400. The other end of the second wire body 430 opposite to the fourth electrical connector 470 is integrally connected to the first end portion 421 of the first wire body 420. Furthermore, in this embodiment, the fourth electrical connector 470 is protrudingly disposed on the third end portion 431.

In this embodiement, the first electrical connection slot 220 and the first electrical connector 440 are complementary in structure and both comply with different signal formats such as HDMI, mini HDMI, micro HDMI, DP (DisplayPort), mini DP, USB, mini USB, micro USB, USB Lightning or USB Type-C. The second electrical connection slot 230 and the third electrical connector 460 are complementary in structure and both comply with different signal formats including HDMI, mini HDMI, micro HDMI, DP, mini DP, USB, mini USB, micro USB, USB Lightning and USB Type-C. The second electrical connector 450 complies with one of signal formats including HDMI (High-Definition Multimedia Interface) input/output, USB Type-C , ALT-mode (e.g., Alternate Mode in USB Type-C) input/output, HID (human interface device) input/output, UVC (USB video device class) input/output, UAC (USB Audio Class) input/output, and MSC (MS System Console) access.

For example, the first electrical connector 440 is a mini HDMI connector, the second electrical connector 450 is an HDMI connector, the third electrical connector 460 is a USB Type-C connector, and the fourth electrical connector 470 is a USB-A connector, however, the present disclosure is not limited thereto.

In addition, the working module 200 further includes a processing unit (not shown) and a signal transceiver portion 240 (Fig. 3). The signal transceiver portion 240 is electrically connected to the wiring board 210 and the first electrical connection slot 220 for connecting a connection interface (not shown) of one of a receiving-end device and a transmitting-end device. The receiving-end device is, for example, a television, a projector or other similar mobile devices, however, the present disclosure is not limited thereto. The transmitting-end device is, for example, the signal source device mentioned above, however, the disclosure is not limited thereto. The processing unit is fixedly disposed on the wiring board 210 and electrically connected to the signal transceiver portion 240, the first electrical connection slot 220 and the second electrical connection slot 230 to convert the electrical signal of the signal source device and transmit the converted electrical signal from the signal transceiver portion 240 to the receiving-end device.

Also, in the embodiement, the signal transceiver portion 240 is a wireless transmission unit (e.g., WIFI, Bluetooth transmission element etc), which can be connected to the above-mentioned signal source device wirelessly. However, the present disclosure is not limited thereto. In other embodiments, the signal transceiver portion 240 may also be altered to an electrical connection slot that can be wiredly connected to the signal source device, and the signal transceiver portion 240 and the first electrical connection slot 220 are respectively located on the same side or different sides of the wiring board 210.

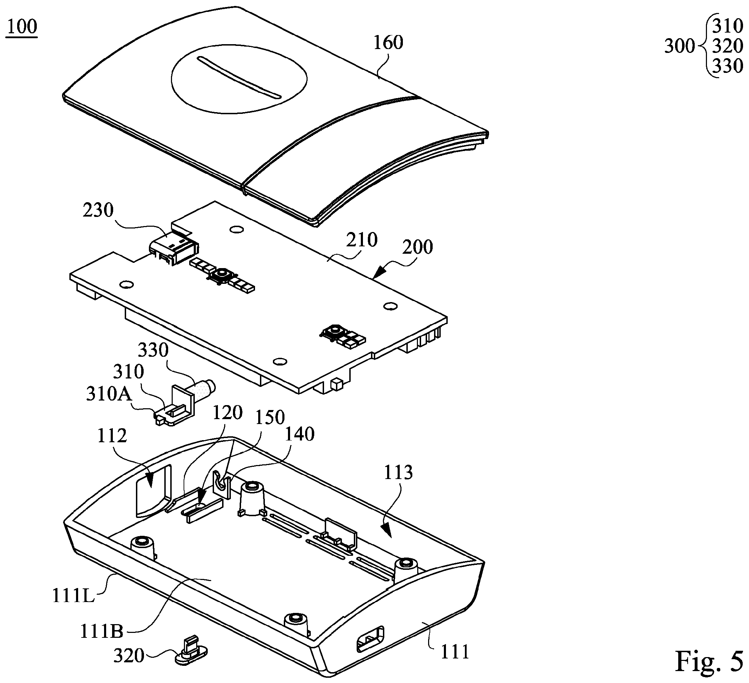

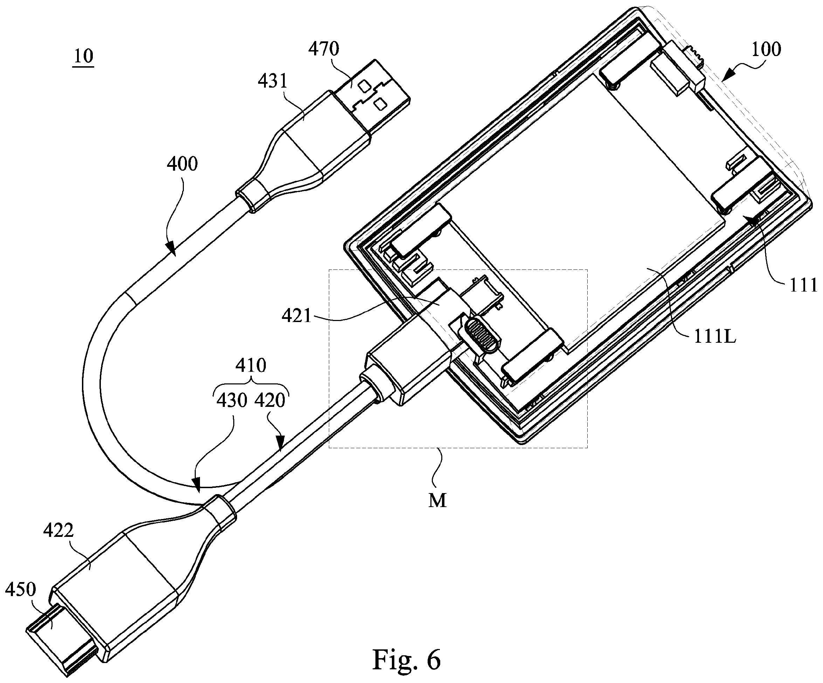

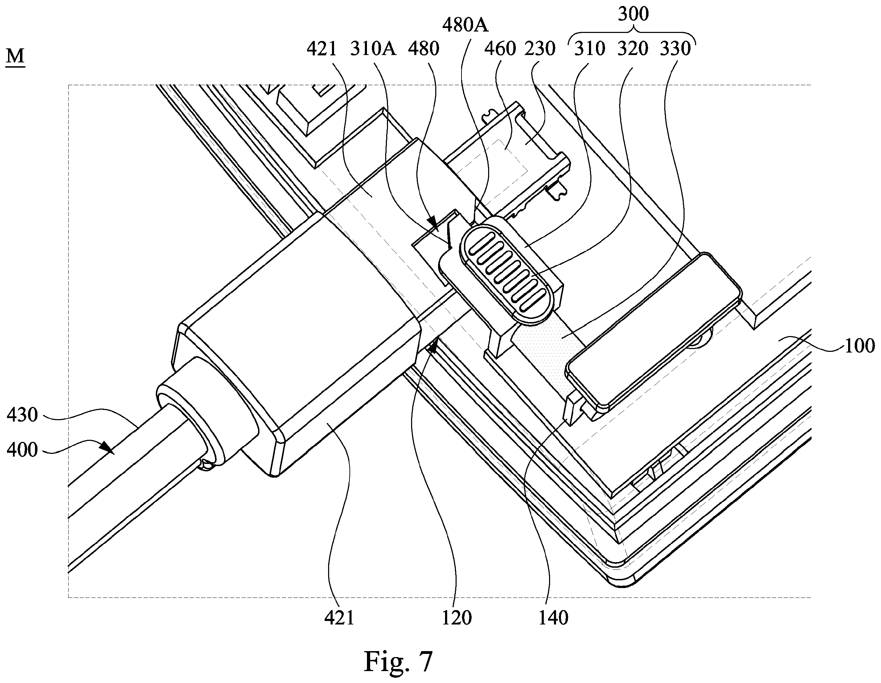

Fig. 5 illustrates an exploded view of the host device 100 shown in Fig. 3 viewed from another aspect. Fig. 6 illustrates a schematic view of the image transmission equipment 10 shown in Fig. 1 viewed from another aspect to see through a bottom shell 111 of the host device. Fig. 7 illustrates a partial enlarged view of an area M in Fig. 6. As shown in Fig. 2 and Fig. 5, when a user inserts the first end portion 421 of the cable body 410 of the transmission line 400 into the plugging-hole 112 and moves the fastening mechanism 300 into the fastening groove 480 (Fig. 7), the transmission line 400 is thus fixed to the host device 100, and vice versa.

As shown in Fig. 2 and Fig. 5 again, more specifically, in this embodiment but not limited thereto, the casing 110 further is provided with a sliding groove 130, a fixing frame 140 and a through hole 150. The sliding groove 130 and the fixing frame 140 are respectively located on a bottom surface 111B of the bottom shell 111, and the through hole 150 is formed on the bottom surface 111B of the bottom shell 111 to be connected to the bottom surface 111B and the outer surface 111L of the bottom shell 111.For example, the bottom shell 111 includes two partition boards 120. The partition boards 120 are spaced arranged on the bottom surface 111B of the bottom shell 111 to form the aforementioned sliding groove 130 together, and the aforementioned through hole 150 located between the partition boards 120.

The fastening mechanism 300 is provided with a hook body 310, an operated portion 320 and an elastic member 330. The hook body 310 is movably located on the fixing frame 140 and slidably located in the sliding groove 130 for moving into or outwards from the fastening groove 480. One side of the hook body 310 is further provided with a second guiding inclined surface 310A. The elastic member 330 is connected to the hook body 310 and the fixing frame 140, respectively, and the operated portion 320 is located on an outer surface 111L of the casing 110, and connected to the hook body 310 within the receiving groove 113 through the through hole 150 for driving the hook body 310 to slide back and forth linearly.

Thus, as shown in Fig.2 and Fig. 7, when the user is desired to plug the first end portion 421 of the transmission line 400 into the host device 100, the first guiding inclined surface 480A of the first end portion 421 pushes the second guiding inclined surface 310A of the hook body 310, so that the hook body 310 can partially extend out of the fixing frame 140 and simultaneously compress the elastic member 330 until the hook body 310 is aligned with the fastening groove 480. The restoring force of the elastic member 330 pushes the hook body 310 into the fastening groove 480 (Fig. 7), thereby fixing the first end portion 421 of the transmission line 400 in the host device 100. On the contrary, when the user exerts force to push the operating portion 320 to move the hook body 310 to be pulled back from the fastening groove 480, the user can pull the transmission line 400 out of the host device 100 (Fig. 2). Until the user stops exerting force on the operating portion 320, the restoring force of the elastic member 330 can bring the hook body 310 back to its original position.

However, the fastening mechanism 300 of the present disclosure is not limited to the above structure, and other fixing manners such as sliding switches or tight-fitting buckles may also be interchangeable according to needs or limitations.

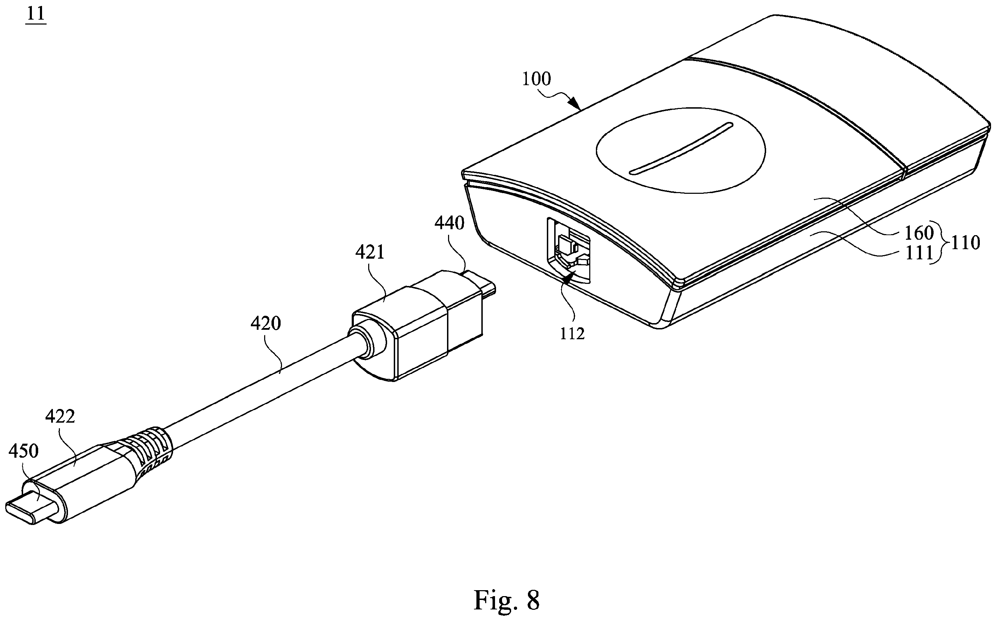

Fig. 8 illustrates an exploded view of an image transmission equipment 11 according to one embodiment of the present disclosure. As shown in Fig. 8, the image transmission equipment 11 of this embodiment is substantially the same as the image transmission equipment 10 of the above embodiment, and the difference is that the image transmission equipment 11 can also be replaced with another transmission line 401 in order to match the format of the connction interface of other signal source devices. In this embodiment, the other transmission line 401 includes a first wire body 420, a first electrical connector 440 and a second electrical connector 450. The first electrical connector 440 and the second electrical connector 450 are respectively located at two opposite ends (e.g., the first end portion 421 and the second end portion 422) of the first wire body 420. The first electrical connector 440 and the second electrical connector 450 are of the same specification, and the first electrical connector 440 is used to be pluggably connected to the second electrical connection slot 230. The first electrical connector 440 and the second electrical connector 450 comply with different signal formats such as HDMI, mini HDMI, micro HDMI, DP (DisplayPort), mini DP, USB, mini USB, micro USB, USB Lightning or USB Type-C .

However, the present disclosure is not limited to this. In other embodiments, since the other transmission line 401 only needs to be electrically connected to the second electrical connection slot 230 of the wiring board 210 through the first electrical connector 440 (refer to Fig.3), the image transmission equipment 11 may also omit the first electrical connection slot 220 and leave the second electrical connection slot 230 (refer to Fig. 3).

Thus, through the above structure, the image transmission equipment and its host device disclosed herein are capable of quickly replacing cables to perform different signal conversions, which not only effectively simplifies the installation and disassembly operations, but also greatly improves the convenience of use thereby not increasing additional costs and reducing the trouble caused by use.

## Claims

1. An image transmission equipment (10), comprising:
a host device (100) comprising a casing (110), a working module (200) and a fastening mechanism (300), the working module (200) comprising a wiring board (210), a first electrical connection slot (220) and a second electrical connection slot (230), the wiring board (210) that is fixed within the casing (110), the second electrical connection slot (230) and the first electrical connection slot (220) which are respectively fixedly located at two opposite surfaces of the wiring board (210), and collectively located on the same side of the wiring board (210), and the fastening mechanism (300) that is movably located within the casing (110); and
a transmission line (400) comprising a cable body (410) comprising a first wire body (420) and a second wire body (430), a fastening groove (480), a first electrical connector (440), a second electrical connector (450), a third electrical connector (460) and a fourth electrical connector (470), the first electrical connector (440) and the second electrical connector (450) which are respectively located at two opposite ends of the cable body (410), and the first electrical connector (440) that is pluggably connected to the first electrical connection slot (220), and the second electrical connector (450) that is used to connect a signal source device, and the fastening groove (480) that is located on the cable body (410), the first wire body (420) comprising a first end portion (421) and a second end portion (422) which are opposite to each other, the first end portion (421) loading the first electrical connector (440), the second end portion (422) loading the second electrical connector (450), and the fastening groove (480) that is recessed on a surface of the first end portion (421), one end of the second wire body (430) that is provided with a third end portion (431), and the other end of the second wire body (430) that is integrally connected to the first end portion (421) of the first wire body (420), the third electrical connector (460) and the first electrical connector (440) that are stacked together inside the first end portion (421) of the first wire body (420), and the third electrical connector (460) is pluggably connected to the second electrical connection slot (230), and the third end portion (431) of the second wire body (430) loads the fourth electrical connector (470), and the fourth electrical connector (470) is electrically connected to the third electrical connector (460) by the second wire body (430) connected to the signal source device,
wherein when the first electrical connector (440) is connected to the first electrical connection slot (220), the transmission line (400) synchronously connects the third electrical connector (460) to the second electrical connection slot (230), and the fastening mechanism (300) is moved into the fastening groove (480), the transmission line (400) is fixed on the host device (100).

2. The image transmission equipment (10) of claim 1, wherein the casing (110) is provided with a sliding groove (130), a fixing frame (140) and a through hole (150), which are located on a bottom surface (111B) of the casing (110), respectively; and
the fastening mechanism (300) is provided with a hook body (310), an operated portion (320) and an elastic member (330), the hook body (310) is movably located on the fixing frame (140) and slidably located in the sliding groove (130) for moving into the fastening groove (480), the elastic member (330) is connected to the hook body (310) and the fixing frame (140), respectively, and the operated portion (320) is located on an outer surface (111L) of the casing (110), and connected to the hook body (310) through the through hole (150).

3. The image transmission equipment (10) of any one of claims 1 to 2, wherein the first electrical connection slot (220) and the first electrical connector (440) are complementary in structure, and the first electrical connection slot (220) and the first electrical connector (440) both comply with one of signal formats including HDMI, mini HDMI, micro HDMI, DP, mini DP, USB, mini USB, micro USB, USB Lightning and USB Type-C.

4. The image transmission equipment (10) of any one of claims 1 to 3, wherein the second electrical connector (450) complies with one of signal formats including HDMI input/output, USB Type-C, ALT-mode input/output, HID input/output, UVC input/output, UAC input/output, and MSC access.

5. The image transmission equipment (10) of any one of claims 1 to 4, wherein the working module (200) further comprises a signal transceiver portion (240) electrically connected to the wiring board (210) and the first electrical connection slot (220), and used to connect to one of a receiving-end device and a transmitting-end device.

6. The image transmission equipment (10) of claim 5, wherein the signal transceiver portion (240) and the first electrical connection slot (220) are respectively located on the same side or different sides of the wiring board (210).

## Patentansprüche

1. Bildübertragungsgerät (10), umfassend:
eine Host-Vorrichtung (100), umfassend ein Gehäuse (110), ein Arbeitsmodul (200) und einen Befestigungsmechanismus (300), wobei das Arbeitsmodul (200) eine Verdrahtungsplatine (210), einen ersten Schlitz (220) zur elektrischen Verbindung und einen zweiten Schlitz (230) zur elektrischen Verbindung umfasst, die Verdrahtungsplatine (210), die innerhalb des Gehäuses (110) befestigt ist, den zweiten Schlitz (230) zur elektrischen Verbindung und den ersten Schlitz (220) zur elektrischen Verbindung, die jeweils fest an zwei gegenüberliegenden Flächen der Verdrahtungsplatine (210) positioniert sind und gemeinsam auf derselben Seite der Verdrahtungsplatine (210) positioniert sind, und den Befestigungsmechanismus (300), der beweglich innerhalb des Gehäuses (110) positioniert ist; und
eine Übertragungsleitung (400), umfassend einen Kabelkörper (410), der einen ersten Drahtkörper (420) und einen zweiten Drahtkörper (430) umfasst, eine Befestigungsnut (480), einen ersten elektrischen Verbinder (440), einen zweiten elektrischen Verbinder (450), einen dritten elektrischen Verbinder (460) und einen vierten elektrischen Verbinder (470), den ersten elektrischen Verbinder (440) und den zweiten elektrischen Verbinder (450), die jeweils an zwei gegenüberliegenden Enden des Kabelkörpers (410) positioniert sind, und den ersten elektrischen Verbinder (440), der steckbar mit dem ersten Schlitz (220) zur elektrischen Verbindung verbunden ist, und den zweiten elektrischen Verbinder (450), der zum Verbinden einer Signalquellenvorrichtung verwendet wird, und die Befestigungsnut (480), die an dem Kabelkörper (410) positioniert ist, wobei der erste Drahtkörper (420) einen ersten Endabschnitt (421) und einen zweiten Endabschnitt (422) umfasst, die einander gegenüberliegen, wobei der erste Endabschnitt (421) den ersten elektrischen Verbinder (440) trägt, der zweite Endabschnitt (422) den zweiten elektrischen Verbinder (450) trägt, und die Befestigungsnut (480), die an einer Oberfläche des ersten Endabschnitts (421) vertieft ist, ein Ende des zweiten Drahtkörpers (430), das mit einem dritten Endabschnitt (431) bereitgestellt ist, und das andere Ende des zweiten Drahtkörpers (430), das einstückig mit dem ersten Endabschnitt (421) des ersten Drahtkörpers (420) verbunden ist, den dritten elektrischen Verbinder (460) und den ersten elektrischen Verbinder (440), die innerhalb des ersten Endabschnitts (421) des ersten Drahtkörpers (420) übereinander angeordnet sind, und wobei der dritte elektrische Verbinder (460) steckbar mit dem zweiten Schlitz (230) zur elektrischen Verbindung verbunden ist und der dritte Endabschnitt (431) des zweiten Drahtkörpers (430) den vierten elektrischen Verbinder (470) trägt, und wobei der vierte elektrische Verbinder (470) durch den zweiten Drahtkörper (430), der mit der Signalquellenvorrichtung verbunden ist, elektrisch mit dem dritten elektrischen Verbinder (460) verbunden ist,
wobei, wenn der erste elektrische Verbinder (440) mit dem ersten Schlitz (220) zur elektrischen Verbindung verbunden ist, die Übertragungsleitung (400) den dritten elektrischen Verbinder (460) synchron mit dem zweiten Schlitz (230) zur elektrischen Verbindung verbindet, und wobei der Befestigungsmechanismus (300) in die Befestigungsnut (480) bewegt wird, die Übertragungsleitung (400) an der Host-Vorrichtung (100) befestigt ist.

2. Bildübertragungsgerät (10) nach Anspruch 1, wobei das Gehäuse (110) mit einer Schiebenut (130), einem Befestigungsrahmen (140) und einem Durchgangsloch (150) bereitgestellt ist, die jeweils auf einer unteren Fläche (111B) des Gehäuses (110) positioniert sind; und
der Befestigungsmechanismus (300) mit einem Hakenkörper (310), einem Betätigungsabschnitt (320) und einem elastischen Element (330) bereitgestellt ist, wobei der Hakenkörper (310) beweglich an dem Befestigungsrahmen (140) positioniert ist und verschiebbar in der Schiebenut (130) positioniert ist, um in die Befestigungsnut (480) bewegt zu werden, wobei das elastische Element (330) jeweils mit dem Hakenkörper (310) und dem Befestigungsrahmen (140) verbunden ist und der Betätigungsabschnitt (320) an einer Außenfläche (111L) des Gehäuses (110) positioniert ist und durch das Durchgangsloch (150) mit dem Hakenkörper (310) verbunden ist.

3. Bildübertragungsgerät (10) nach einem der Ansprüche 1 bis 2, wobei der erste Schlitz (220) zur elektrischen Verbindung und der erste elektrische Verbinder (440) in ihrer Struktur komplementär sind und der erste Schlitz (220) zur elektrischen Verbindung und der erste elektrische Verbinder (440) beide einem von Signalformaten entsprechen, die HDMI, Mini-HDMI, Mikro-HDMI, DP, Mini-DP, USB, Mini-USB, Mikro-USB, USB Lightning und USB Typ-C beinhalten.

4. Bildübertragungsgerät (10) nach einem der Ansprüche 1 bis 3, wobei der zweite elektrische Verbinder (450) einem von Signalformaten entspricht, die HDMI-Eingang/-Ausgang, USB Typ-C, ALT-Modus-Eingang/-Ausgang, HID-Eingang/-Ausgang, UVC-Eingang/-Ausgang, UAC-Eingang/-Ausgang und MSC-Zugriff beinhalten.

5. Bildübertragungsgerät (10) nach einem der Ansprüche 1 bis 4, wobei das Arbeitsmodul (200) ferner einen Signal-Transceiver-Abschnitt (240) umfasst, der elektrisch mit der Verdrahtungsplatine (210) und dem ersten Schlitz (220) zur elektrischen Verbindung verbunden ist und zur Verbindung mit einer von einer empfangsseitigen Vorrichtung und einer sendeseitigen Vorrichtung verwendet wird.

6. Bildübertragungsgerät (10) nach Anspruch 5, wobei der Signal-Transceiver-Abschnitt (240) und der erste Schlitz (220) zur elektrischen Verbindung jeweils auf derselben Seite oder auf unterschiedlichen Seiten der Verdrahtungsplatine (210) positioniert sind.

## Revendications

1. Équipement de transmission d'images (10), comprenant :
un dispositif hôte (100) comprenant un boîtier (110), un module de fonctionnement (200) et un mécanisme d'attache (300), le module de fonctionnement (200) comprenant une carte de câblage (210), une première fente de connexion électrique (220) et une seconde fente de connexion électrique (230), la carte de câblage (210) qui est fixée à l'intérieur du boîtier (110), la seconde fente de connexion électrique (230) et la première fente de connexion électrique (220) qui sont respectivement situées de manière fixe au niveau de deux surfaces opposées de la carte de câblage (210), et situées collectivement du même côté de la carte de câblage (210), et le mécanisme d'attache (300) qui est situé de manière mobile à l'intérieur du boîtier (110) ; et
une ligne de transmission (400) comprenant un corps de câble (410) comprenant un premier corps de fil (420) et un second corps de fil (430), une rainure d'attache (480), un premier connecteur électrique (440), un deuxième connecteur électrique (450), un troisième connecteur électrique (460) et un quatrième connecteur électrique (470), le premier connecteur électrique (440) et le deuxième connecteur électrique (450) qui sont respectivement situés aux deux extrémités opposées du corps de câble (410), et le premier connecteur électrique (440) qui est connecté par enfichage à la première fente de connexion électrique (220), et le deuxième connecteur électrique (450) qui est utilisé pour connecter un dispositif de source de signal, et la rainure d'attache (480) qui est située sur le corps de câble (410), le premier corps de fil (420) comprenant une première partie d'extrémité (421) et une seconde partie d'extrémité (422) qui sont opposées l'une à l'autre, la première partie d'extrémité (421) chargeant le premier connecteur électrique (440), la seconde partie d'extrémité (422) chargeant le second connecteur électrique (450), et la rainure d'attache (480) qui est évidée sur une surface de la première partie d'extrémité (421), une extrémité du second corps de fil (430) qui est pourvue d'une troisième partie d'extrémité (431), et l'autre extrémité du second corps de fil (430) qui est connectée en un seul tenant à la première partie d'extrémité (421) du premier corps de fil (420), le troisième connecteur électrique (460) et le premier connecteur électrique (440) qui sont empilés ensemble à l'intérieur de la première partie d'extrémité (421) du premier corps de fil (420), et le troisième connecteur électrique (460) est connecté par enfichage à la seconde fente de connexion électrique (230), et la troisième partie d'extrémité (431) du second corps de fil (430) charge le quatrième connecteur électrique (470), et le quatrième connecteur électrique (470) est électriquement connecté au troisième connecteur électrique (460) par le second corps de fil (430) connecté au dispositif de source de signal,
dans lequel, lorsque le premier connecteur électrique (440) est connecté à la première fente de connexion électrique (220), la ligne de transmission (400) connecte de manière synchrone le troisième connecteur électrique (460) à la seconde fente de connexion électrique (230), et le mécanisme d'attache (300) est déplacé dans la rainure d'attache (480), la ligne de transmission (400) est fixée sur le dispositif hôte (100).

2. Équipement de transmission d'images (10) selon la revendication 1, dans lequel le boîtier (110) est pourvu d'une rainure coulissante (130), d'un cadre de fixation (140) et d'un trou traversant (150), qui sont situés sur une surface inférieure (111B) du boîtier (110), respectivement ; et
le mécanisme d'attache (300) est pourvu d'un corps de crochet (310), d'une partie actionnée (320) et d'un élément élastique (330), le corps de crochet (310) est situé de manière mobile sur le cadre de fixation (140) et situé de manière coulissante dans la rainure de coulissement (130) pour se déplacer dans la rainure d'attache (480), l'élément élastique (330) est relié au corps de crochet (310) et au cadre de fixation (140), respectivement, et la partie actionnée (320) est située sur une surface extérieure (111L) du boîtier (110), et reliée au corps de crochet (310) à travers le trou traversant (150).

3. Équipement de transmission d'images (10) selon l'une quelconque des revendications 1 à 2, dans lequel la première fente de connexion électrique (220) et le premier connecteur électrique (440) sont de structure complémentaire, et la première fente de connexion électrique (220) et le premier connecteur électrique (440) sont tous deux conformes à l'un des formats de signal comprenant HDMI, mini HDMI, micro HDMI, DP, mini DP, USB, mini USB, micro USB, USB Lightning et USB Type-C.

4. Équipement de transmission d'images (10) selon l'une quelconque des revendications 1 à 3, dans lequel le deuxième connecteur électrique (450) est conforme à l'un des formats de signal comprenant une entrée/sortie HDMI, USB Type-C, entrée/sortie en mode Alt, entrée/sortie HID, entrée/sortie UVC, entrée/sortie UAC et accès MSC.

5. Équipement de transmission d'images (10) selon l'une quelconque des revendications 1 à 4, dans lequel le module de fonctionnement (200) comprend en outre une partie d'émetteur-récepteur de signal (240) électriquement connectée à la carte de câblage (210) et à la première fente de connexion électrique (220), et utilisée pour se connecter à l'un d'un dispositif d'extrémité de réception et d'un dispositif d'extrémité d'émission.

6. Équipement de transmission d'images (10) selon la revendication 5, dans lequel la partie d'émetteur-récepteur de signal (240) et la première fente de connexion électrique (220) sont respectivement situées sur le même côté ou sur des côtés différents de la carte de câblage (210).
